Europäisches Patentamt

European Patent Office

Office européen des brevets

(11) Veröffentlichungsnummer: **0 219 701**
A2

## (12) EUROPÄISCHE PATENTANMELDUNG

(21) Anmeldenummer: 86112996.3

(22) Anmeldetag: 20.09.86

(51) Int. Cl.⁴: **H 03 K 5/24**
H 03 K 5/08

(30) Priorität: 19.10.85 DE 3537315

(43) Veröffentlichungstag der Anmeldung:
29.04.87 Patentblatt 87/18

(84) Benannte Vertragsstaaten:
CH DE GB IT LI NL SE

(71) Anmelder: Richard Hirschmann Radiotechnisches Werk
Richard-Hirschmann-Strasse 19 Postfach 110
D-7300 Esslingen a.N.(DE)

(72) Erfinder: Zierhut, Hermann, Dipl.-Ing.
Waldperlacher Strasse 21
D-8000 München 83(DE)

(74) Vertreter: Stadler, Heinz, Dipl.-Ing.
Richard-Hirschmann-Strasse 19 Postfach 110
D-7300 Esslingen a.N.(DE)

(54) Komparator-Schaltung.

(57) Für eine Komparator-Schaltung wird ein Operationsverstärker zur Erzeugung einer Vergleichsspannung bzw. Schaltschwelle verwendet, der dem Offset-Nullabgleich dienende Balance-Anschlüsse aufweist. Diese Balance-Anschlüsse werden mit Spannungen beaufschlagt, die die Offset-Spannung in gewünschter Weise bewußt vergrößert, die als Schaltschwellenspannung für die Komparator-Schaltung verwendet wird. In einfachster Weise wird dadurch eine Schwellenspannung für die Komparator-Schaltung insbesondere im mV-Bereich erzeugt, so daß das zu vergleichende Signal, das in diesem Spannungsbereich liegt, nicht noch verstärkt werden muß, wie dies bei der Verwendung der Schaltspannung von Transistoren als Schaltschwelle erforderlich ist.

EP 0 219 701 A2

Richard Hirschmann

Radiotechnisches Werk

Richard-Hirschmann-Str. 19

7300 Esslingen a.N.

0219701

17.10.1985

TPA/Stad/ka

Patentanmeldung

## Komparator-Schaltung

Die Erfindung betrifft eine Komparator-Schaltung mit fest eingestellter Schaltschwelle.

Bei Komparator-Schaltungen herkömmlicher Art wird für den Vergleich des zu vergleichenden Signals mit einer Schaltschwelle üblicherweise ein Transistor verwendet, dessen Sperrspannung von ca. 0,6 Volt als Schaltschwelle benutzt wird. Wenn das zu vergleichende Signal im µV-Bereich liegt, wie dies etwa bei Schaltungsanordnungen für Raumüberwachungseinrichtungen der Fall ist, muß dieses Sensorsignal auf den Bereich der Schaltschwelle von ca. 0,6 Volt verstärkt werden, um einen Vergleich und damit eine Alarmsignalauslösung zu ermöglichen. Die hohe Verstärkung erfordert einen erheblichen Schaltungsaufwand und kann die sichere Funktion der Komparatorwirkung durch auftretende Störkomponenten gefährden.

Der Erfindung liegt die Aufgabe zugrunde, eine Komparatorschaltung zu schaffen, die eine hohe Verstärkung des Sensorsignals zu Vergleichszwecken mit einer Schaltschwelle nicht erfordert, einen einfachen Aufbau aufweist und einen sicheren Vergleich des zu vergleichenden Signals mit einem Vergleichssignal bzw. einer Schaltschwelle ermöglicht.

Die gestellte Aufgabe wird erfindungsgemäß durch die im kennzeichnenden Teil des Anspruchs 1 angegebenen Merkmale gelöst. Vorteilhafte Ausführungsformen der Erfindung sind in den Unteransprüchen angegeben.

Bei einem idealen Operationsverstärker ist die Offset-Spannung, d.h.

die Spannungsdifferenz zwischen dem Minus- und dem Plus-Anschluß 0 Volt. Dies wird in der Praxis jedoch nicht erreicht, vielmehr weisen die auf dem Markt erhältlichen Operationsverstärker Offset-Spannungen von 1 mV bis 15 mV auf. In vielen Anwendungsfällen ist diese Toleranz der Spannungsdifferenz nicht akzeptabel; es werden vielmehr häufig ideale Operationsverstärker mit einer Offset-Spannung von 0 mV benötigt. Daher sind Operationsverstärker auf dem Markt, die zusätzlich zu den üblichen Anschlüssen zwei weitere Anschlüsse, nämlich die sogenannten Balance-Anschlüsse aufweisen, die mit entsprechenden Spannungen beaufschlagt werden, um die dem Operationsverstärker eigene Offset-Spannung abzugleichen. Durch entsprechende Wahl der an den Balance-Anschlüssen anliegenden Spannungen kann daher ein Nullabgleich der dem Operationsverstärker eigenen Offset-Spannung vorgenommen werden.

Die vorliegende Erfindung nützt nun derartige Operationsverstärker mit herausgeführtem Balance-Nullabgleich aus, um dem Operationsverstärker über diese Balance-Anschlüsse eine Spannung aufzuprägen, mit der die Offset-Spannung nicht auf Null abgeglichen, sondern umgekehrt bewußt vergrößert wird. Je nach den an die Balance-Anschlüsse angelegten Spannungen und je nach dem Typ des Operationsverstärkers lassen sich daher bewußt und künstlich hervorgerufene Offset-Spannungen im mV-Bereich etwa zwischen 10 und 50 mV erzeugen. Die vorliegende Erfindung beruht auf der Untersuchung derartiger Operationsverstärker mit Balance-Anschlüssen und der bewußten Umkehrung des Offset-Nullabgleichs zur Erzeugung einer bewußt großen, künstlichen Offset-Spannung, die als Schwellwertspannung bzw. Schaltschwelle für eine Komparatorschaltung verwendet wird.

Durch einen einfachen Operationsverstärker mit Balance-Anschlüssen lassen sich daher in denkbar einfacher Weise Vergleichsspannungen bzw. Schaltschwellen im mV-Bereich erzeugen. Dies hat zusätzlich den Vorteil, daß zu vergleichende Signale, die im µV-Bereich liegen, wie dies bei Raumüberwachungsdetektoren der Fall ist, lediglich auf einen Spannungswert im mV-Bereich und nicht wie bei der Verwendung von Transistoren als Schaltschwellenerzeuger auf 600 mV verstärkt werden müssen. Dadurch kann eine Verstärkungsschaltung eventuell ganz entfallen bzw. eine einfachere Verstärkerschaltung mit kleinerem Verstärkungsfaktor verwendet werden, was zu einer einfacheren Gesamt-Schaltungsanordnung führt.

Gemäß einer bevorzugten Ausführungsform der Erfindung ist ein Balance-Anschluß des Operationsverstärkers an die Minus-Betriebsspannungsklemme (Masse) und/oder der andere Balance-Anschluß an die Plus-Betriebsspannungsklemme, erforderlichenfalls je über einen Widerstand, angeschlossen. Dadurch ergeben sich auf einfachste Weise die den Balance-Anschlüssen bereit zu stellenden Spannungen, so daß die Schaltungsanordnung noch weiter vereinfacht ist.

Im Zusammenhang mit Reihenuntersuchungen von Operationsverstärkern mit herausgeführten Balance-Anschlüssen hat sich erstaunlicherweise gezeigt, daß einige dieser Operationsverstärker, insbesondere der Typ µA-741, bei praktisch allen Exemplaren eine sehr konstante Schaltschwelle aufweist, wenn der Operationsverstärker in der erfindungsgemäßen Weise zur Erzeugung der Schaltschwelle betrieben wird. Diese Operationsverstärker-Typen sind daher für die Anwendung nach der vorliegenden Erfindung besonders gut geeignet, da die einzelnen Exemplare bei der Fertigung von Komparatorschaltungen nicht einzeln abgeglichen zu werden brauchen, sondern jeweils ein Widerstand mit demselben Widerstandswert von z.B. 1 MOhm für den Anschluß an die Plus-Betriebsspannungsquelle verwendet werden kann. Die verschiedenen Exemplare dieses Operationsverstärkertyps zeigen dann dieselbe konstante Offset-Spannung, die je nach Wahl des besagten Widerstandswerts in einem Bereich von 10 bis 50 mV gewählt werden kann.

Obgleich die erfindungsgmäße Verwendung eines Operationsverstärkers mit Balance-Anschlüssen allgemein zur Erzeugung von Schwellwertspannungen und Schaltschwellen benutzt werden kann, ist eine Verwendung diese Erfindung im Zusammenhang mit Einbruchmeldeanlagen besonders

- 4 -

vorteilhaft, bei denen der Detektor in der Strom-Betriebsart, auch unter der Bezeichnung Current-Mode bekannt, arbeitet, wie dies in der älteren Patentanmeldung P 35 28 646.6 desselben Anmelders und Erfinders ausführlich erläutert ist. Ein solcher Detektor liefert ein Ausgangssignal in der Größenordnung von 10 bis 50 mV, so daß dieses Ausgangssignal dann der Komparatorstufe ohne Verwendung eines weiteren Verstärkers zum Vergleich mit einer Schaltschwelle zugeführt werden kann. Dadurch wird der Schaltungsaufwand noch weiter verringert.

Bei den zuvor beschriebenen Ausführungsformen der erfindungsgemäßen Komparatorschaltung wurde die bewußt erzeugte bzw. vergrößerte Offset-Spannung des Operationsverstärkers durch Anlegen von Spannungen an die herausgeführten Balance-Anschlüsse erzeugt. Von dem Erfindungsgedanken ebenfalls umfaßt ist die Ausführungsform eines Operationsverstärkers, der in sich bereits so ausgebildet ist bzw. dessen aus einer integrierten Schaltung bestehendes Bauelement so aufgebaut ist, daß die Offset-Spannung zum Zwecke einer Erzeugung einer bestimmten Spannungsdifferenz einen vorgegebenen Wert aufweist. Durch entsprechenden Schaltungsaufbau des Operationsverstärkers bzw. durch interne Wahl der Widerstände kann dann an die Balance-Anschlüsse direkt, also ohne Verwendung eines zusätzlichen Widerstands, die Betriebsspannung angelegt werden.

Patentansprüche

1. Komparator-Schaltung mit fest eingestellter Schaltschwelle, dadurch gekennzeichnet, daß ein Operationsverstärker mit zwei herausgeführten, dem Offset-Nullabgleich dienenden Balance-Anschlüssen zur Erzeugung der Schaltschwelle vorgesehen ist, die mit entsprechenden Spannungen zur bewußten Vergrößerung der als Schaltschwellenspannung dienenden Offset-Spannung des Operationsverstärkers beaufschlagt werden.

2. Komparator-Schaltung nach Anspruch 1, dadurch gekennzeichnet, daß ein Balance-Anschluß des Operationsverstärkers an die Minus-Betriebsspannungsklemme (Masse) und/oder der andere Balance-Anschluß an die Plus-Betriebsspannungsklemme angeschlossen ist.

3. Komparator-Schaltung nach Anspruch 2, dadurch gekennzeichnet, daß wenigstens einer der Balance-Anschlüsse über einen Widerstand an die Minus- bzw. an die Plus-Betriebsspannungsklemme angeschlossen ist.

4. Komparator-Schaltung nach einem der Ansprüche 1 bis 3, dadurch gekennzeichnet, daß eine positive und eine negative fest eingestellte Schaltschwelle und für jede Schaltschwelle ein Operationsverstärker vorgesehen ist, und daß wenigstens einer der Balance-Anschlüsse des jeweiligen Operationsverstärkers über denselben Widerstand an die Minus- bzw. Plus-Betriebsspannungsklemme angeschlossen ist.